# EUROPÄISCHE PATENTANMELDUNG

(11) **EP 0 539 334 A2**
(43) Veröffentlichungstag der Anmeldung: **28.04.1993**
(21) Anmeldenummer: 92810817.4
(22) Anmeldetag: 21.10.1992
(51) Int. Cl.: G03B 27/02, G03B 27/58

(54) **Verfahren zur Maskierung bei der Herstellung von Druckformen und Maskierfolie zur Durchführung des Verfahrens**

(30) Priorität: 22.10.1991 CH 3085/91
(71) Anmelder: LÜSCHER AG MASCHINENBAU, CH-5725 Leutwil (CH)
(72) Erfinder: Berner, Peter, CH-5102 Rupperswil (CH)
(74) Vertreter: White, William

(57) **Zusammenfassung**

Für die Maskierung von Druckplatten sind vier Maskierfolien (1) vorgesehen, die ausserhalb der Druckplatten-Umrandung senkrecht zur Ebene der Druckplatte aufgestellt sind. Mittels Stachelrädern lassen sich die Maskierfolien (1) sehr genau einstellen. Die Maskierfolien (1) sind dazu seitlich über und unter derselben mit Transport-Bändern (2a,2b) versehen, die Randplatte (1b) ist innerhalb der Transport-Bänder (2) mit einem Verstärkungs-Band (3a,3b) versehen. Das Maskierband (1c) trägt oben und unten ein Kanten-Band (4,10) und über dem oberen Kanten-Band (4) eine Halteschiene (6). Damit liegt die Maskierfolie (1) mit ihrer Maskierkante (1c) satt auf der Druckplatte auf und es kann dadurch keine Bildverfälschung durch Streulicht geben.

## Beschreibung

Die vorliegende Erfindung betifft ein Verfarhen zur Maskierung bei der Herstellung von Druckformen gemäss dem Oberbegriff des unabhängigen Patentanspruchs 1 sowie eine Maskierfolie zur Durchführung des Verfahrens gemäss dem Oberbegriff des Patentanspruchs 4.

Bei der Druckform-Herstellung von Offset-Platten wird die lichtempfindliche Schicht oft in mehreren Schritten belichtet. Dazu wird die unbelichtete Offset-Platte auf eine Glasplatte gelegt, die an ihrer Unterseite mit Kanälen versehen ist, durch die Luft angesaugt werden kann, um sie mit dem erzeugten Unterdruck zu haltern. Eine solche Anordnung ist in der EP-A-0 317 529 beschrieben.

Ein Problem das sich beim Abdecken der Stellen, die nicht zu belichten sind, ergeben kann, entsteht unter anderem dadurch, dass die Abdeckung nicht satt auf der Offset-Platte aufliegt, sondern sich wellen kann, wodurch Streulichtfehler entstehen können.

Es ist deshalb eine Aufgabe der Erfindung ein Verfahren zum Maskieren von Druckfomen und eine dazu geeignete Maskierfolie zu schaffen, so dass keine Streulichtfehler entstehen.

Erfindungsgemäss wird dies durch ein Verfahren erreicht, das durch die Merkmale im kennzeichnenden Teil des unabhängigen Patentanspruchs 1 gekennzeichnet ist. Eine Maskierfolie zur Durchführung des Verfahrens ist im kennzeichnenden Teil des Patentanspruchs 4 charakterisiert.

Nachfolgend wird die Erfindung an Hand der Zeichnung erläutert. Es zeigen:
Fig. 1 eine Draufsicht auf eine Maskierfolie nach der Erfindung,
Fig. 2 in gedehnter Darstellungsweise und in vergrössertem Massstab den Aufbau der Maskierfolie in der vorderen rechten Ecke gemäss II in Fig. 1,
Fig. 3 in gleicher Darstellung wie in Fig. 2 die hintere rechte Ecke gemäss III in Fig. 1, und
Fig. 4 eine Schnittansicht gemäss der Schnittlinie IV-IV in Fig. 1 einer Variante.

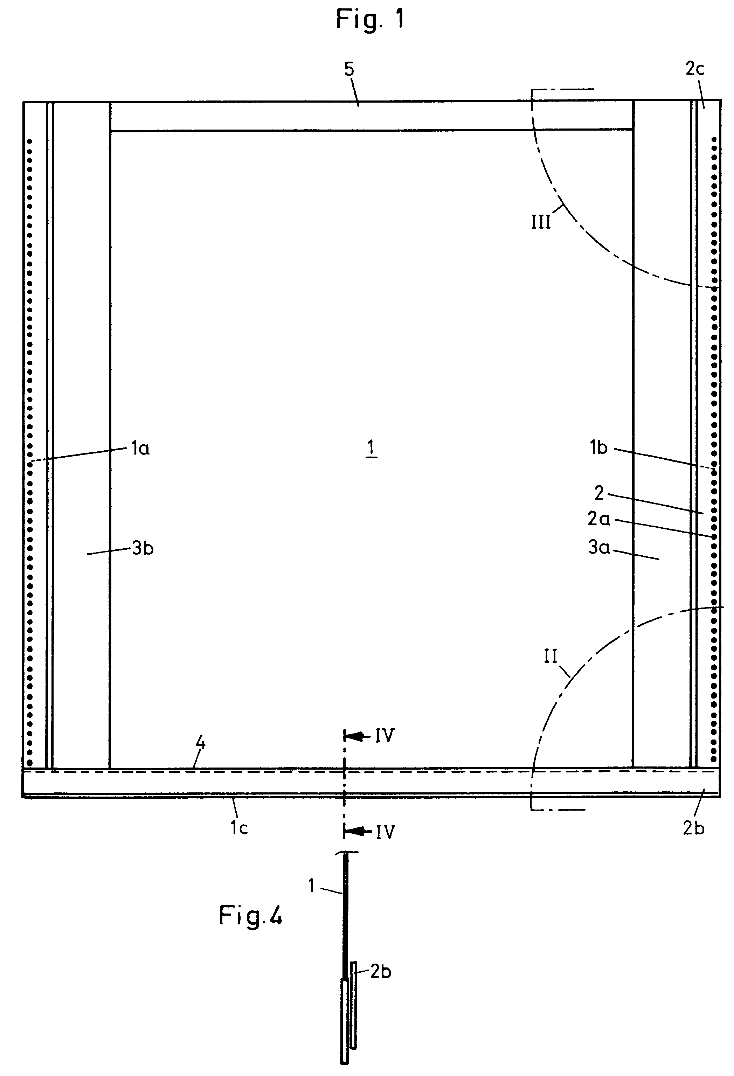

Die abdeckende Folie 1 in Fig. 1 bis 3 ist eine schwarz eingefärbte Polyester-Folie in der Grössenordnung von wenigstens angenähert 600 mm auf 600 mm. Auf diese abdeckende Folie 1 sind auf sich gegenüberliegenden Seitenrändern 1a, 1b oben und unten je ein Transport-Band 2, 8 mit Randlochung 2a aufgeklebt. Dieses Transport-Band kann farblos oder farbig, wie beispielsweise weiss eingefärbt sein. Die vorgesehenen Abmessungen sind z.B. 0,35 mm dick, 20 mm breit und auf die Länge der abdeckenden Folie 1 bemessen. Die Randlochung 2a entspricht den Abmessungen der in der maschinellen Textverarbeitung üblichen Stachelwalzen oder -Räder und haben einen Durchmesser von 4 mm. Auf die Länge der abdeckenden Folie 1 bei einem Freihalte-Endteil 2b, 2c, 8b, 8c von je 25 mm haben diese Transport-Bänder 2, 8 je 68 Löcher.

Einwärts dieser Transport-Bänder 2, 8 sind oben und unten an der abdeckenden Folie 1 Verstärkungsbänder 3, 9 aus Bandstahl im Abstand von den Transport-Bändern 2, 8 befestigt. Der Abstand beträgt z.B. 5 mm. Dieser Bandstahl ist für diese Verstärkungsbänder 3, 9 je 0,15 mm dick und 50 mm breit. Die Länge ist natürlich ebenso gross wie die der Transport-Bänder 2, 8.

Die vordere Kante 1c der abdeckenden Folie 1 ist für die vorgesehene Verwendung zum Maskieren von Offset-Platten die wichtigste Kante. Sie muss flach auf der abzudeckenden Unterlage aufliegen, damit kein Streulicht unter den Rand gelangen kann. Bündig mit der Kante 1c ist ein oberes Kanten-Band 4 und ein unteres Kanten-Band 10 vorgesehen. Diese beiden Kanten-Bänder 4, 10 sind gleichartig aus Bandstahl und sind 0,3 mm dick, 25 mm breit und haben eine der Breite der abdeckenden Folie 1 entsprechende Länge von etwa 600 mm.

Die Transport-Bänder 2, 8 und die Verstärkungs-Bänder 3, 9 werden durch die beiden Kanten-Bänder 4, 10 bis zur Aussenkante der Transport-Bänder 2, 8 überdeckt. Auf das obere Kanten-Band 4 ist eine Halteschiene 6 aufgesetzt. Diese Halteschiene 6 dient der Versteifung der Vorderkante 1c der Folie 1 und besteht ebenfalls aus Stahl. Die Abmessungen sind: Dicke 5 mm, Breite 20 mm und die Längae ist 50 mm kürzer als die Breite der Folie 1. Damit wird das obere Kanten-Band 4 nur über den Abstand zwischen den Aussenkanten des linken und rechten oberen Verstärkungs-Bandes 3a, 3b überdeckt.

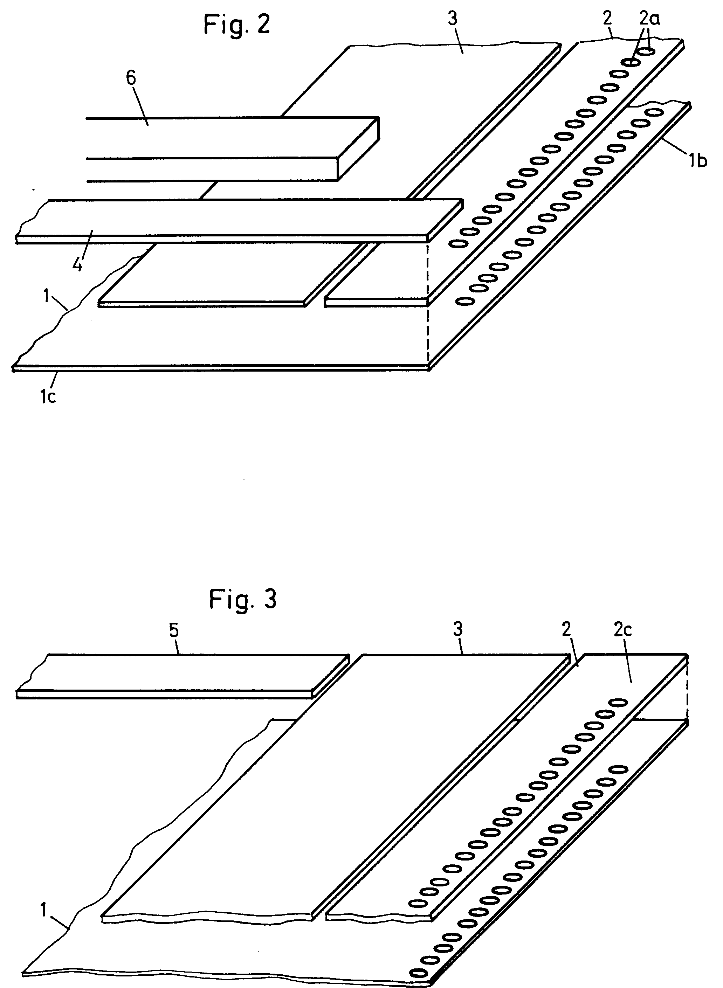

Die Anordnung für die Transport-Bänder 2, 8 und die Verstärkungs-Bänder 3, 9 wurde an Hand der Zeichnung für die in Fig. 2 und 3 dargestellte rechte Seite der Folie 1 gemäss Fig. 1 beschrieben. Selbstverständlich ist die Anordnung für die gegenüberliegende Seite identisch aber spiegelverkehrt.

Eine derartige Anordnung für eine Maskierfolie hat den Vorteil, dass die Lage der vorderen Kante 1c der Folie 1 sehr genau mittels zweier auf einer gemeinsamen Achse befestigten Stachelrädern mittels eines Einstellmotors, wie beispielsweise einem Schrittmotor, eingestellt werden kann.

Da alle Bländer an den Seitenpartien 1a, 1b der Folie 1, nämlich die Transport-Bänder 2, 8 und die Verstärkungs-Bänder 3, 9 biegeweich sind lassen sich solcherart aufgebaute Maskierfolien problemlos um die Stachelräder für deren Transport biegen, nämlich von der horizontalen Abdecklage zu einer vertikalen Wartelage.

In einer Verbesserung der streustrahlungsfreien, geradlinigen Abdeckung könnte gemäss Fig. 4 vorn eine Stahlbandkante 11 vorgesehen sein. Diese hätte dann in etwa dieselbe Dicke wie die Folie 1. Die Befestigung dieser Stahlbandkante 11 an der Folie 1 wird mit den Kanten-Bändern 4 und 10 bewirkt, die durch einfaches Kleben sich sowohl an der Stahlbandkante 11 als auch an der Folie 1 halten.

## Patentansprüche

1. Verfahren zur Maskierung bei der Herstellung von Druckformen für Offset-Platten mit einer Auflage aus Glas für die Offset-Platten und mit Maskierfolien zum Abdecken der nicht zu belichtenden Flächen, dadurch gekennzeichnet, dass Maskierfolien (1) von vier rechtwinklig aufeinanderstehenden Seiten aus soweit über die jeweilige Offset-Platte gelegt werden, dass die gesamte äussere Fläche bis auf das zu belichtende Fenster verdeckt ist.

2. Verfahren nach Patentanspruch 1, dadurch gekennzeichnet, dass die Maskierfolien (1) ausserhalb der Fläche der Offset-Platte um 90 Grad umgebogen werden.

3. Verfahren nach Patentanspruch 2, dadurch gekennzeichnet, dass die Maskierfolie nach oben umgebogen werden.

4. Maskierfolie zur Durchführung des Verfahrens nach Patentanspruch 1 oder 2, dadurch gekennzeichnet, dass eine schwarz eingefärbte Kunststoffolie (1) an ihrer Maskierkante (1c) sowohl an ihrer oberen Fläche als auch an ihrer unteren Fläche je mit wenigstens einen Maskierstahlband (6,10) versehen ist, dass ferner die beiden Seitenkanten beidseits der Folie (1) mit seitlichen Kunststofftransport-Bändern (2,8) mit Randlochung (2a) versehen sind, und dass von den beiden Kunststofftransport-Bändern (2,8) gegen das innere Gebiet der Kunststoffolie (1) hin je ein seitliches Stahlband (3,9) auf dieselbe aufgesetzt ist.

5. Maskierfolie nach Patentanspruch 4, dadurch gekennzeichnet, dass die seitlichen Kunststofftransport-Bänder (2,8) von den seitlichen Stahlbändern (3,9) beabstandet sind.

6. Maskierfolie nach Patentanspruch 4, dadurch gekennzeichnet, dass auf das obere Markierstahl-Band (4) ein Flachstahl-Band (6) aufgesetzt ist.

7. Maskierfolie nach einem der Patentansprüche 4 bis 6, dadurch gekennzeichnet, dass sämtliche Kunststoff- (2,8) und Stahl-Bänder (3,9,5,4,10) auf die Kunststoffolie (1) aufgeklebt sind.

8. Maskierfolie nach Patentanspruch 7, dadurch gekennzeichnet, dass das obere Maskierstahl-Band (4) jeweils nur in den Randgebieten geklebt ist.

9. Maskierfolie nach Patentanspruch 6, dadurch gekennzeichnet, dass das Flachstahl-Band (6) um die Breiten der seitlichen Kunststofftransport-Bänder (2,8) kürzer ist als das obere Maskierstahl-Band (4).
